# EUROPEAN PATENT SPECIFICATION

(11) **EP 1 945 586 B1**
(45) Date of publication and mention of the grant of the patent: **29.08.2018**
(21) Application number: 06826210.4
(22) Date of filing: 19.10.2006
(51) Int. Cl.: C03C 17/00, C03C 17/30, C30B 15/10

(54) **QUARTZ GLASS CRUCIBLE AND METHOD FOR TREATING SURFACE OF QUARTZ GLASS CRUCIBLE**
QUARZGLASTIEGEL UND VERFAHREN ZUR BEHANDLUNG DER OBERFLÄCHE EINES QUARZGLASTIEGELS
CREUSET DE VERRE QUARTZEUX ET PROCÉDÉ DE TRAîTEMENT DE SURFACE DE CREUSET DE VERRE QUARTZEUX

(30) Priority: 19.10.2005 US 728216 P
(43) Date of publication of application: 23.07.2008
(73) Proprietor: Momentive Performance Materials Inc., Waterford, NY 12188 (US)
(72) Inventor: HANSEN, Richard, Lee, Mentor, OH 44060 (US); DEVANATHAN, Narsi, Solon, OH 44139 (US); KIRCHER, Theodore, P., Ashtabula, OH 44004 (US)
(74) Representative: Laufhütte, Dieter
(86) International application number: PCT/US2006/040758
(87) International publication number: WO 2007/047783

(56) References cited:
- EP-A- 1 304 399
- EP-A1- 0 319 736
- EP-A2- 1 408 015
- US-A1- 2003 012 898
- US-A1- 2005 178 319

## Description

### FIELD OF THE INVENTION

The present invention relates to quartz glass crucibles used for pulling a silicon single crystal in the semiconductor industry, and methods for treating the surface of such quartz glass crucibles.

### BACKGROUND OF THE INVENTION

Single crystal silicon, which is the starting material for most semiconductor electronic component fabrication, is commonly prepared by the so-called Czochralski ("Cz") method. Using the Cz method, the growth of the crystal is carried out in a crystal-pulling furnace, wherein polycrystalline silicon ("polysilicon") is charged to a crucible and melted by a heater surrounding the outer surface of the crucible sidewall. A seed crystal is brought into contact with the molten silicon and a single crystal ingot is grown by extraction via a crystal puller. In this pulling process, the quartz glass crucible is subjected for several hours to high mechanical, chemical and thermal stress that it must withstand without undergoing appreciable plastic deformation. The larger the crucible and thus the volume of melt to be received therein, the longer the melting times usually are.

US Patent No. 5976247 discloses a process to enhance the thermal stability of the quartz glass crucible, wherein the crucible is provided with a surface layer of cristobalite. The melting point of cristobalite of about 1720°C is much higher than the melting temperatures of conventional semiconductor materials (e.g., 1420°C for a silicon melt). To generate the cristobalite surface layer, the glassy outer wall of a quartz crucible is treated with a chemical solution containing substances that are conducive to the devitrification of quartz glass into cristobalite ("crystallization promoters"), e.g., alkali metals, alkaline-earth metals, heavy transition metals and barium hydroxide or barium carbonate. When the quartz glass crucible is heated up to a temperature exceeding 1420°C, the surface of the pre-treated crucible wall crystallizes as it transforms to cristobalite, resulting in a higher mechanical and thermal strength of the quartz glass crucible. The devitrification is persistent and provides an improved degree of control to the dissolution of the crucible surface.

US Patent Publication No. 2005/0178319 discloses providing a quartz glass crucible with a crystallization promoter containing a first component acting as a network former and / or network modifier in quartz glass, and a second alkali-metal free component acting as a breakpoint former in quartz glass, e.g., a ternary oxide such as barium titanate, barium zirconate or a mixture thereof. US Publication No. 2003/0211335 discloses providing a fused quartz article such as a crucible, with enhanced creep resistance by controlled devitrification, specifically by coating the crucible with a colloidal silica slurry doped with metal cations such as barium, strontium, and calcium, to promote nucleation and growth of cristobalite crystals thus prolonging the life of the quartz article.

EP 1 304 399 A and EP 1 408 015 A refer to coating compositions for crucibles that comprise a crystallization promoter and may additionally comprise a partial hydrolysate of an alkoxysilane oligomer.

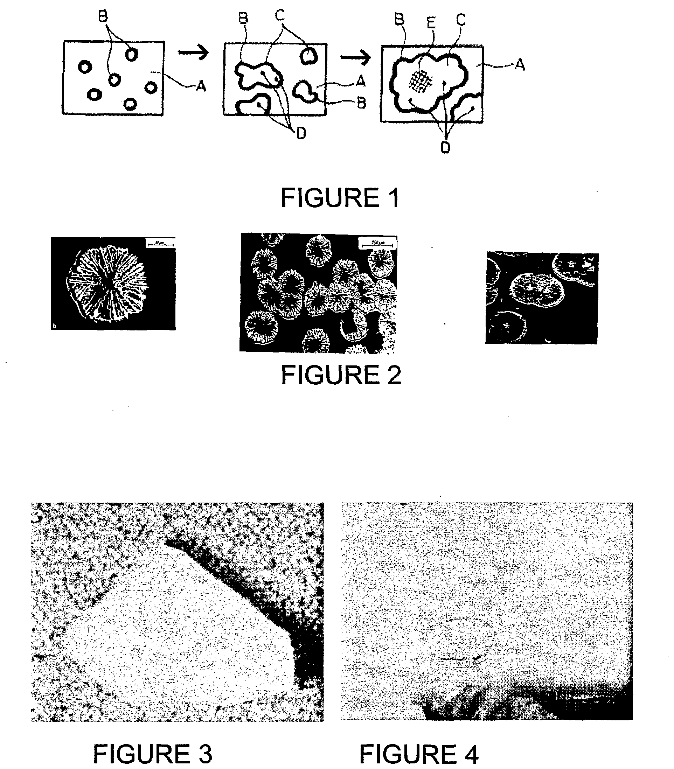

For the silicon melt to dissolve the crucible, it must reduce the surface of the silica (SiO2) first to silicon monoxide (SiO), then break up the network of connected SiO, and finally solvate the individual SiO particles. In US Patent No. 6,280,522, it is disclosed that quartz crucibles, after extended use, develop small ring like patterns (B) on the surface (A) in contact with the silicon melt, and as time elapses, the patterns change in shape and grow in size as illustrated in Figure 1. As time elapses, a white cristobalite layer (C) is formed in a portion encircled by the brown ring, followed by devitrified specs (D) coming out. Eventually, the portion encircled by the expanding brown ring (B) is gradually eroded to expose the glass dissolving surface (E) which was underneath the crystobalite.

While the crystalline portion is being eroded away, it may come loose as fragments, since it is only held down by its bonding to a different phase. Since that bonding is looser than its internal bonding, it may contribute particle fragments to the molten silicon. And as the glass surface (E) is eroded or dissolved, it dissolves non-uniformly and is very likely to let loose particles into the melt which are apt to cause dislocations in the silicon crystal growth and thus reducing the yield. The "brown ring" (B) as illustrated in US Patent No. 6,280,522 is believed to be silica SiO₂ that is reduced to SiO. Figure 3 is a photograph taken at normal (∼1x) magnification showing the brown rings on the surface of an untreated crucible after one crystal pulling run, with individual rosettes as well as small clusters of rosettes.

Upon close examination of the brown rings in Figure 3, one observes individual rosettes (as shown in Figure 2) having low nucleation density with the brown rings being deposits of SiO left on the edge of rosettes. Over time, the rosettes begin to merge with the radial growth increasing until they bump into one another, thus expanding the size of the brown rings of Figure 1. Eventually, portions of the rosettes begin to flake out, and very often it is the center of the rosettes which begin to flake out as illustrated in Figure 4, thus causing pitting corrosion.

Today's perfect silicon crystal is grown under conditions where every effort is made to get a crystal structure as perfect as possible. This is done so as to minimize the number of interstitials as well as the number of silicon vacancies. However, even the best attempts to approach thermodynamic / slow growth conditions still incorporate the vacancies. Since vacancies cannot be eliminated completely, there is a need to reduce the strain on such a lattice with improved quartz glass crucibles. In one embodiment of the invention, a coating comprising at least a thin film of germanium based species are used for quartz glass crucibles that can be of advantage to the crystal grower.

There is also a need for an improved method to extend the life of quartz crucibles for use in silicon crystal growth. The focus in the prior art has been the reduction in the formation of the brown rings. The invention relates to methods to extend the life of quartz crucibles by nucleating other crystalline growth and improving the condition of the rosettes -- and contrary to the prior art teaching - by increasing the number of brown rings formed on quartz crucibles.

### SUMMARY OF THE INVENTION

The invention relates to a quartz glass crucible as defined in claim 1. The invention further relates to a method for preparing a surface of a quartz glass crucible as defined in claim 9.

### DESCRIPTION OF THE DRAWINGS

Figure 1 is a sketching view showing examples of stages of formation of brown rings and devitrified specks, observed on an inner surface of a conventional quartz glass crucible.
Figure 2 is a series of Microphotographs taken at approximately 100x magnification (scale showing the proportionate length of 250 µm), showing the rosette crystal structure nucleation stages from an individual "rosette" (the inner part of a brown ring), merged rosettes, and finally forming devitrified specks with center flake out, as observed on an inner surface of a conventional quartz glass crucible.
Figure 3 is a photograph taken with a camera at approximately 1 X magnification, illustrating a coupon sample from a conventional quartz glass crucible made without any coating, an untreated crucible of the prior art, showing a close up picture of "brown rings" containing rosettes on an inner surface of the crucible.
Figure 4 is a photograph taken at 1 to 2 X magnification as a slight close-up (note finger tip for size reference), showing a close up of a rosette formed on the surface of an untreated crucible of the prior art, with the center of the rosettes showing evidence of flake-out which is shown as the rough or dull discoloration area within the rosettes.
Figure 5 is a photograph taken at approximately 1 X or normal magnification, illustrating a coupon sample from a crucible made with one embodiment of the coating of the invention, showing the dense formation of "brown rings" containing the robust rosettes as form in the area with applied coating.
Figure 6 is a photograph taken at approximately 1 X or normal magnification, illustrating a coupon sample from a crucible made with a second embodiment of the coating of the invention, with densely formed "brown rings" having robust rosettes.
Figures 7 and 8 are graphs illustrating, analytical results of an embodiment of a comparative test to detect the presence of a reduced chemistry on the crucible.

### DETAILED DESCRIPTION OF THE INVENTION

As used herein, the term "treated" or "coated" may be used interchangeably to refer to treating the crucible surface with the coating of the invention, leaving substantially all of the quartz glass crucible surface (to be in contact with the silicon melt) substantially in either a fully reduced, partially reduced, partially oxidized or fully oxidized state.

As used herein, the term "Redox coating materials," or "Redox coating" (Reduction - Oxidation) refers to a gel or film of coating material for use in treating the surface of the quartz glass crucible in one embodiment In one example, the coating refers to an application of a dispersion of crystalline SiO₂ nuclei over the surface. In a second example, a coating of a sol or gel or film that is reduced relative to fully oxidized SiO₂, e.g., an alkoxysilane gel, an alkoxygermane gel, an alkyl-alkoxy-silane, an alkyl-alkoxy-germane, etc. In another example, the coating comprises a Lewis acid (metal or semi-metal chloride) that reacts at or near room temperature with the surface of the SiO₂ crucible, directly biding the hetero-atoms to the quartz glass surface. In yet a fourth example, the coating comprises a plurality of layers comprising any of the above examples.

As used herein, the term "substantially all of quartz glass crucible surface" indicates that the selected coating, e.g., a nucleation coating, a Redox coating, a Lewis acid coating, etc., is applied to cover a sufficient portion of the intended surface to provide the desired controlled reduction/oxidation state. Also as used herein the term "substantially" or "a sufficient portion" indicates that the quartz surface in contact with the silicon melt is at least 75% covered by the coating in one embodiment In a second embodiment, at least 90% coated. In one embodiment, the coated crucible surface in contact with the silicon melt is at least 50% covered by brown rings having the rosette formation, or alternatively at least 50% covered by an alternate crystalline formation. In a second embodiment, the crucible surface in contact with the silicon melt is at least 75% covered by brown rings having the rosette formation and /or crystalline morphology structures. In a third embodiment, the crucible surface in contact with the silicon melt is at least 80% covered by brown rings having a robust rosette formation and /or crystalline morphology structures. In a fourth embodiment, the coated surface is at least 90% covered by rosettes and / or crystalline morphology structures.

As used herein, the terms "first," "second," and the like do not denote any order or importance, but rather are used to distinguish one element from another, and the terms "the", "a" and "an" do not denote a limitation of quantity, but rather denote the presence of at least one of the referenced item. Furthermore, all ranges disclosed herein are inclusive of the endpoints and are independently combinable.

As used herein, approximating language may be applied to modify any quantitative representation that may vary without resulting in a change in the basic function to which it is related. Accordingly, a value modified by a term or terms, such as "about" and "substantially," may not to be limited to the precise value specified, in some cases.

As used herein, "quartz glass articles" may be used interchangeably with "quartz glass crucibles" "quartz crucibles," "fused quartz crucibles," and "quartz crucible," referring to glass articles that may be subjected for extended period of time to high mechanical, chemical, and thermal stress, and if used for crystal pulling, exposed to molten silicon.

As used, herein, the term "substantially continuous" refers to continuity with or without insignificant breaks.

As used herein, the term "crystalline morphology" may be used interchangeably with "crystalline growth structure." The definition of morphology, as known in the art, can be defined at a macroscopic or microscopic level. In one embodiment, "crystalline morphology" refers to a region wherein the glassy (amorphous) SiO₂ has crystallized into one or more of the several crystalline phases of SiO₂, e.g., crystobalite, tridymite, quartz, etc. These phases may appear or present themselves in different macroscopic structures or shapes. At the microscopic level, the term is defined by the actual crystallite growth faces presented, e.g., crystallite may be presented by 1-0-0, 0-1-0, and 0-0-1 oriented growth faces.

As used herein, the term "rosettes" refers to the hemispherulite growth structure or morphology where it is a hemispherical growth outward from a central nucleus with a flattened depth dimension due to the high viscosity of quartz, therefore having a flattened disk shaped crystal structure. This crystalline structure is usually present with the boundaries of "brown rings" or deposits of SiO left on the edge of rosettes. These structures are sometimes called brown rings.

As used herein, the term crystalline surface structures refers to any and all crystalline phases of SiO2, including or not limited to crystobalite, quartz alpha, quartz beta, tridymite, and others.

Applicants have discovered that the formation of the (SiO) brown rings themselves may be unrelated to the crystal yield. Instead, it is believed that it is the rosette density and condition of the rosettes that correlates to the crystal yield. In one embodiment, the life of quartz crucibles is extended by nucleating the crystalline growth and improving the condition of the rosettes. Additionally and contrary to the prior art teaching, the life is extended by increasing the number of brown rings formed on quartz crucibles. In one embodiment, the quartz glass article life is extended by varying the reduction / oxidation state of the surface of the crucibles in a surface treating process. The inner surface of the glass article, e.g., a crucible is coated with a chemical compound which provides an inner surface (at the molecular level) a species or group that is more reduced than SiO₂, In one improvement, the quartz glass crucible coating incorporates a sufficient amount of germanium substituting for silicon to put a small amount of compression on the lattice, compensating to some degree for the tension put on it by the presence of vacancy clusters.

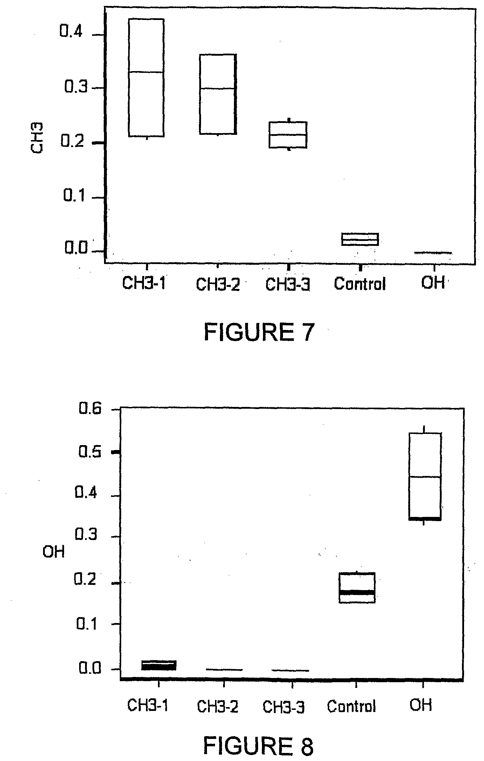

The presence of the coating layer with a reduced chemistry can be tested by known methods, with tests be tailored to detect the plurality of reduced species comprising the reduced surface the testing can be tailored to the potential various reduced coating species. For example, for the detection of a coating surface comprising methylated groups, the coating surface can be analyzed spectrometrically by low angle IR absorbance. Figures 7 and 8 are graphs illustrating analytical results of a test comparing a methylated coating on a quartz crucible vs. a reference standard (crucible with no coating) and a SiO₂ crucible surface that was treated to increase the amount of OH on the surface.

Quartz Glass Crucibles as Starting Materials. Quartz glass crucibles suitable for use as
"starting materials" for surface treating according to the method of the invention are known. In one embodiment, the quartz glass crucible is in the form of a fused quartz crucible, produced using a method as disclosed in U.S. Patent No. 4,416,680.

In another embodiment, the quartz article is in the form of a quartz crucible that has been treated with a crystallization promoter in any of the processes known / disclosed in the art, including US Patent Publication Nos. 2005/0178319 and 2003/0211335, and Japanese Patent Publication No. 08-002932. In yet another embodiment, the quartz crucible is fused using synthetic silica made with residual nitrogen content, for a devitrified inner surface that is uniformly crystallized as disclosed in US Patent No. 6,280,522.

### Embodiments of Nucleation / Redox coatings:

The coating comprises at least an organosilane halogen, or an organogermane halogen, i.e., an organosilane or germane wherein at least a halogen is bonded to the Si or Ge such as an (alkyl)₂SiCl₂, an (alkyl)₂GeCl2, an (alkyl)₂SiBr₂, an (alkyl)₂GeBr2, an (alkyl)₂SiF₂, an (alkyl)₂GeF₂, or an (aryl)₂SiCl₂, an (aryl)₂GeCl₂. Anions include F, Cl, Br, and I. Examples include, but are not limited to, (CH₃) ₂SiCl₂, (CH₃)₂GeCl₂, (CH₃)₂SiBr₂, (CH₃)₂SiF₂, (CH₃)₂GeBr₂. Obviously the organic tails can get more complicated with longer alkyl groups. In one embodiment, the Redox containing comprises at least one of dichlorosilane SiH₂Cl₂ and dichlorodimethylsilane (CH₃)₂SiCl₂.

Embodiments of solvents: Solvents for used with the coatings of the invention are known in the art. Examples of suitable solvents include alkyl halides like chloroform, carbon tetrachloride, trichloroethane, trichloropropane, and similar C4, C5, C6, C7, etc. compounds.

End-Use Applications of the Treated Quartz Glass Article: The treated articles are quartz crucible for use in growing single silicon crystal. After treatment, the surface of the crucible is left in either a fully reduced, partially reduced, partially oxidized or fully oxidized state, such that the reduction/oxidation state of the crucible's finished surface is controlled for optimized performance in a Czochralski crystal puller.

The surface with reduced chemical species by themselves or as a result of physical reactions and physical restructuring during the beginning of the Czochralski cycle nucleate. In operation upon contact with the silicon melt, there is a redox chemistry taking place at high temperatures followed by solvation chemistry. There is a natural tendency for uncontrolled nucleation of rosettes by some unknown species. With the treated crucible surfaces of the invention, the likelihood of crystalline silicon dioxide crystal nucleation, crystal growth and /or rosette growth is significantly increased. This is to be contrasted with the treatment of quartz crucible surfaces with a barium compound, for example, where the crystalline structure produced is distinctly different from rosettes. In one embodiment, some of crystalline structures that are nucleated and grown are similar to the rosettes, and some structures are similar to the growth structures seen in a barium carbonate coated crucible.

In one embodiment of a treated quartz crucible, the surface of crucible is left with physical nuclei attached to the surface, e.g., a dispersal of crystalline silicon dioxide compounds to act as nuclei for crystal growth. In a second embodiment, the surface is left with metal cations which react to the surface of the quartz crucible in operation. In a third embodiment, the surface is covered with a gel or film in either a fully reduced, partially reduced, partially oxidized or fully oxidized state, such that the reduction/oxidation state of the crucible's finished surface is controlled for optimized performance in a Czochralski crystal puller.

In yet another embodiment with the presence of germanium in the treated quartz glass article surface, it is believed that if incorporated into the silicon crystal, the germanium provides crystal stress relieve from vacancy incorporation. The germanium atom puts a small amount of compression on the lattice, thus compensating to some degree for the tension put on it by the presence of vacancy clusters.

Methods for Applying Surface Coating: In one embodiment, a solution for coating is first prepared by diluting the coating material in a suitable solvent. Examples of solvents which can be used for a Redox coating include halogenated alkane solvents, saturated aliphatic alcohols containing no more than 10 carbon atoms, aliphatic and aromatic hydrocarbons, ethers, aliphatic and aromatic nitriles and aromatic amines. Examples of solvents which can be for OH reactive embodiments include halogenated alkane solvents. In one embodiment wherein the Redox coating material is a silane, the molarity of the silane containing molecules in a solution is in the range of 0.1 to 1 millimolar.

In yet another embodiment, a solution for coating is first prepared by slurrying a finely ground crystalline powder in a tetramethoxysilane or tetramethoxygermane, diluting it in methanol or ethanol, and then applying it to the quartz glass surface and allowing the solvent to evaporate. In the next step, the treated surface can be air cured, hydrolyzed, or heated to low temperatures (30 to 300°C) to accelerate the film drying and off-gassing of methanol.

The coatings may be applied on the quartz glass surface using methods known in the art, including manual methods such as brushing or a mechanically assisted method such as dip coating (self-assembly molecular coating), spin coating, spraying, and chemical vapor deposition. Dip coating can be performed for 1 minute or more. Spin coating can be performed at speeds of 20 to 2,500 rpm. In yet another embodiment, spin coating is performed at a speed of 300 to 2000 rpm.

In one embodiment of a coating process, the coating is applied such that the quartz crucible remains in contact with the solution containing the coating for a time sufficient to leave a film of the coating containing molecules on the quartz crucible surface. In one embodiment, the quartz crucible surface remains in contact with the solution containing the Redox coating for about for a period of 30 seconds to 15 minutes.

In one embodiment, a sufficient amount of coating material is applied for the coated quartz article for the article with the reduced chemistry surface to have a service life of at least 50% longer upon exposure to silicon melt, than an uncoated surface. In yet another embodiment, a sufficient amount of coating material is applied for the article to have a service life of at least 75% longer than an uncoated crucible.

In one embodiment of the invention, the coating is applied in a sufficient amount for the crucibles to remain in operation of at least 60 hours and at a temperature of in excess of 1420°C. In a second embodiment at a temperature of in excess of 1420°C, the crucibles remain in operation of at least 90 hours. In a third embodiment, the service life of the crucible is at least 120 hours.

The thickness of the coating varies depending on the type of coating to be applied as well as the application method. In one embodiment, the thickness of the coating on the quartz crucible is controlled to the thickness of a single layer. In one embodiment, the coating is applied approximately equal to a length of one molecule of a coating layer containing silane molecules. In another embodiment, the overall thickness is dependent on the number of desirable layers to be formed, 2-5 lengths of one molecule. In one embodiment, the thickness of the coating is between 0.1 µm (100 nm) to 1 µm. In another embodiment, the thickness is between 0.2 to 0.5 µm. In other embodiments, the thickness may be greater than 100µm

In one embodiment, the entire inner surface of the quartz glass crucible is substantially coated with the coating for a substantially continuous layer, i.e., at least 75% of the surface to be coated, and in a contiguous manner to the extent possible. In another embodiment, only the part of the quartz glass crucible subsequently in contact with the silicon melt is treated with the Redox coating. In yet another embodiment, the inner surface of the quartz glass crucible to be in contact with silicon melt is substantially coated to produce a substantially continuous layer of the coating, i.e., at least 80% of the crucible surface in contact with the melt is coated and in a contiguous manner to the extent possible.

In one embodiment after coating, the treated quartz glass article is annealed at a temperature in a range of 100°C to 150°C for a period of time ranging from 20 to 40 minutes prior to being placed in operation.

In one embodiment prior to the application of the coating, the quartz crucible surface is optionally "prepared" for coating by pre-treating by humidifying or exposing the surface to moist air. In one embodiment, the surface is treated by being immersed in water to ensure hydration of the surface, or cleaning prior to the application of the Lewis acid reactive coating material.

In one embodiment, the crucible surface is optionally prepared using a method as disclosed in U.S. Patent No. 6,302,957, wherein the surface is cleaned by an acid such has hydrofluoric acid and / or nitric acid, then optionally followed by heat treatment at > 1600°C.

In another embodiment, the crucible surface is first optionally treated with an outer coating comprising at least a metal cation, e.g., cations of barium, calcium, and strontium, for controlled devitrification as disclosed in U.S. Patent Publication No. 2003/0211335.

In one embodiment, after the optional treating step and prior to the application of the Redox coating, the quartz crucible surface is prepared by creating a surface chemical state to optimize the binding of the Redox agent In one embodiment, the crucible surface is first washed or cleaned with silicon tetrachloride (SiCl₄) in an anhydrous environment, essentially to create a surface of dangling Cl ligands. In the next step, the quartz glass surface is coated with a Redox coating material, e.g., (CH₃)₂SiCl₂, or an aminosilane such as (CR₃)₃SiN(CH₃)₂, CH₃SiH₂N(CH₃)₂, or (CH₃)₂SiHN(CH₃)₂.

In another example of the method of the invention, after the crucible surface is "prepared" by being washed or reacted with silicon tetrachloride (SiCl₄), the crucible surface is then allowed to hydrolyze with moisture in the air to produce a surface covered with Si-OH bonds. In the next step, the crucible surface is coated or treated with an organosilane such as (CH₃)₂SiCl₂ to maximize the extent of the surface coverage of the methyl groups for the crucible.

In yet another example, the quartz glass surface is first treated with chlorine gas essentially to create a surface of dangling Cl ligands, then subsequent coated with a Redox coating in a solution.

Examples: Examples are provided herein to illustrate the invention but are not intended to limit the scope of the invention.

Example 1: A untreated crucible from GE Quartz of Willoughby, Ohio, USA is first washed with silicon tetrachloride, then subsequently coated with a Redox coating of (CH₃)₂SiCl₂ dissolved in 1,1,1 trichloroethane at a ratio of 1:4. The coating is done manually by brushing the entire crucible surface with the solution, with the excess being wiped off.

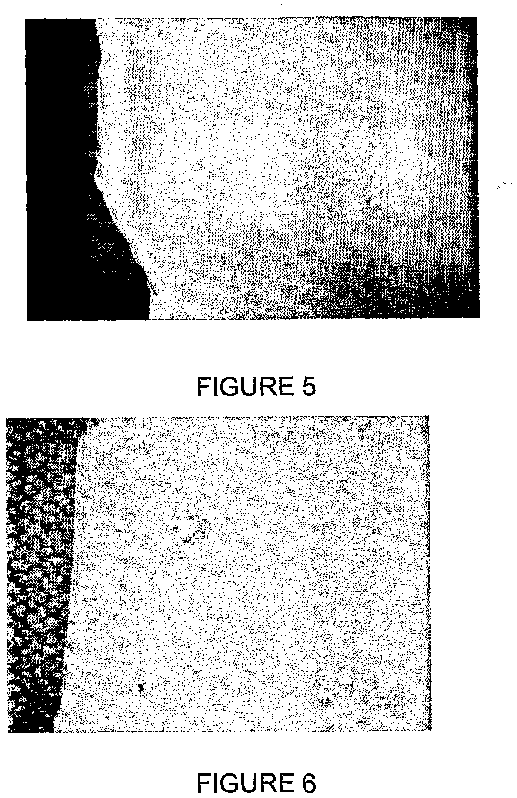

In operation and after the first Czochralski crystal pulling run, a number of densely formed brown rings are observed on parts of the coated crucible surface as shown in Figure 5. The crucible surface develops a higher than normal density of rosettes (as represented by the brown rings) of at least 50 %, compared to the number of brown rings appearing on an untreated crucible after such a crystal pulling run. Further, the rosettes are stable for the entire length of the run and show no degradation in the center.

Besides the increased number of "brown rings" or density of rosettes, the rosettes are more well formed and appear to be thicker than the rosettes formed in the brown rings of a crucible untreated by the Redox coating of the invention. In close-up examination as illustrated in Figure 6, it is observed that the rosettes formed within the brown rings have a very robust structure, i.e., with the brown rings being thick and distinct in appearance, and additionally, without showing little if any sign of having center flake out as in the rosettes in the untreated crucible of the prior art.

Example 2: A coupon cut from an untreated crucible from GE Quartz of Willoughby, Ohio, USA is first washed with silicon tetrachloride, then subsequently coated with a Redox coating of (CH₃)₂SiCl₂ dissolved in 1,1,1 trichloroethane at a ratio of 1:4. The coating is done manually by brushing the entire crucible surface with the silane solution. After coating, the excess solvent evaporates leaving the coating in place. The excess byproduct of the coating chemical is removed and the crucible is ready to use.

The coupon is exposed to melted silicon at a temperature in excess of 1420°C and for 30 to 60 hours, simulating the condition of a Czochralski crystal pulling run. The coupon is removed from the melted silicon and observed under microphotography. Densely formed brown rings are observed covering at least 80% of the surface of the coupon (previously treated with the Redox coating). Additionally, the rosettes within the brown rings appear to be very thick and very robust, with no evidence of flaking shown.

Example 3: In this example, an untreated 22 inch crucible from GE Quartz of Newark, Ohio, USA was tested in a silicon crystal pulling operation vs. an embodiment of a crucible of the invention, a 22 inch crucible that was first washed with silicon tetrachloride, then subsequently coated with a Redox coating of (CH₃)₂SiCl₂ dissolved in 1,1,1 trichloroethane, at a ratio of 1:4 per procedure in Example 2. The yield after the first pass for the untreated crucible was less than ½ of the yield obtained for the coated crucible of the invention. Yield is measured as inches of good silicon crystal obtained from a run.

Example 4: Untreated 22 inch crucible vs. the crucible prepared according to Example 2, a 22 inch crucible coated a Redox coating of (CH₃)₂SiCl₂ dissolved in 1,1,1 trichloroethane at a ratio of 1:4 were tested in a Czochralski run to measure the throughput. Throughput is defined as kilograms per hour of silicon obtained in a crystal pull. The average first pass throughput for the crucible of the invention was up to 3 times the average first pass throughput obtained from an uncoated crucible.

## Claims

1. A quartz glass crucible for use in growing single silicon crystal in a Czochralski operation and being exposed to a silicon melt, wherein the crucible contains at least 99.0% SiO₂ and comprises:
a surface having coated thereon a coating material providing a plurality of chemical species having a reduced chemistry on the coated surface, wherein the coating material comprises an organosilane halogen or an organogermane halogen, wherein the coating material covers at least 75% of the crucible surface exposed to the silicon melt.

2. The crucible of claim 1, wherein the coating material covers at least 90% of the crucible surface exposed to the silicon melt.

3. The crucible of any preceding claim, wherein the coating material comprises a least one of trialkylchlorogermane; dialkyldichlorogermane, dialkyldihalogensilane and dialkyldihalogengermane.

4. The crucible of claim 3, wherein the coating material comprises at least one of an (alkyl)₂GeCl₂, an (alkyl)₂GeBr₂, an (alkyl)₂GeF₂, and an (aryl)₂GeCl₂, and mixtures thereof.

5. The crucible of any preceding claim, wherein the coating material comprises at least one of an (alkyl)₂SiCl₂, an (alkyl)₂SiBr₂, an (alkyl)₂SiF₂, and an (aryl)₂SiCl₂, and mixtures thereof.

6. The crucible of any preceding claim, wherein the coating material further comprises a powdered crystalline material and preferably crystalline silica.

7. The crucible of claim 6, wherein the crystalline material has an average particle size of less than 50 µm and preferably less than 20 µm.

8. The crucible of claim 6 or 7, wherein the crystalline material is alpha quartz, beta quartz or crystobalite.

9. A process for preparing at least a surface of a quartz glass crucible for exposure to a silicon melt in growing single silicon crystal in a Czochralski operation, the process comprising:
coating at least 75% of the surface to be exposed to the silicon melt with a coating material comprising an organosilane halogen or an organogermane halogen, and mixtures thereof.

10. The process of claim 9, further comprising the steps of:
dissolving the coating material in a solvent selected from the group of alkanes, halogenated alkanes, alcohols, and mixtures thereof;
coating the surface of the crucible by applying the dissolved coating material on the crucible surface to be exposed to the silicon melt.

11. The process of claim 9 or 10, wherein the coating material is applied by one of:
spraying the coating material onto the crucible, brushing the coating material onto the crucible, dipping the crucible into the coating material, and combinations thereof.

12. The process of claim 9, further comprising the steps of:
forming a slurry comprising a powdered crystalline material and an organosilane halogen or an organogermane halogen;
dissolving the slurry in a solvent selected from the group of alkanes, halogenated alkanes, alcohols, and mixtures thereof;
coating the surface of the crucible by applying the dissolved slurry on the crucible surface to be exposed to the silicon melt; and
annealing the coated crucible at a temperature in a range of 100°C to 150°C for 20 to 40 minutes.

13. The process of claim 12, wherein the solvent is selected from the group of chloroform, carbon tetrachloride, trichloroethane, trichloropropane, methanol, ethanol, n-propanol, isopropanol, n-butanol, t-butanol, n-octanol, n-decanol, ethylene glycol, hexane, decane, isooctane, benzene, toluene, the xylenes, dioxane, diethyl ether, dibutyl ether, bis(2-methoxyethyl)ether, 1 ,2-dimethoxyethane, butane, pentane, hexane, dichloromethane, trichloromethane, tetrachloromethane, 1,2-dichloroethane, trichloroethylene; 1,1,1 trichloroethane, a tetrachloroethylene, and chlorobenzene;

14. The process of claim 12 or 13, wherein the coating material is applied by one of:
spraying the coating material onto the crucible, brushing the coating material onto the crucible, dipping the crucible into the coating material, and combinations thereof.

## Patentansprüche

1. Quarzglastiegel zur Verwendung beim Züchten von Siliziumeinkristall in einem Czochralski-Verfahren, welcher einer Siliziumschmelze ausgesetzt wird, wobei der Tiegel mindestens 99,0% SiO₂ enthält und umfasst:
eine Oberfläche mit einem darauf aufgebrachten Beschichtungsmaterial, welches mehrere chemische Spezies mit einer reduzierten Chemie auf der beschichteten Oberfläche vorsieht, wobei das Beschichtungsmaterial ein Organosilanhalogen oder ein Organogermanhalogen umfasst, wobei das Beschichtungsmaterial mindestens 75% der der Siliziumschmelze ausgesetzten Tiegeloberfläche bedeckt.

2. Tiegel nach Anspruch 1, wobei das Beschichtungsmaterial mindestens 90% der der Siliziumschmelze ausgesetzten Tiegeloberfläche bedeckt.

3. Tiegel nach einem vorhergehenden Anspruch, wobei das Beschichtungsmaterial mindestens eines von Trialkylchlorgerman; Dialkyldichlorgerman, Dialkyldihalogensilan und Dialkyldihalogengerman umfasst.

4. Tiegel nach Anspruch 3, wobei das Beschichtungsmaterial mindestens eines von einem (Alkyl)₂GeCl₂, einem (Alkyl)₂GeBr₂, einem (Alkyl)₂GeF₂ und einem (Aryl)₂GeCl₂ und Mischungen derselben umfasst.

5. Tiegel nach einem vorhergehenden Anspruch, wobei das Beschichtungsmaterial mindestens eines von einem (Alkyl)₂SiCl₂, einem (Alkyl)₂SiBr₂, einem (Alkyl)₂SiF₂ und einem (Aryl)₂SiCl₂ und Mischungen derselben umfasst.

6. Tiegel nach einem vorhergehenden Anspruch, wobei das Beschichtungsmaterial weiterhin ein pulverförmiges kristallines Material und bevorzugt kristallines Siliziumdioxid umfasst.

7. Tiegel nach Anspruch 6, wobei das kristalline Material eine mittlere Partikelgröße von unter 50 µm und bevorzugt unter 20 µm aufweist.

8. Tiegel nach Anspruch 6 oder 7, wobei das kristalline Material Alpha-Quarz, Beta-Quarz oder Cristobalit ist.

9. Prozess zum Herstellen mindestens einer Oberfläche eines Quarzglastiegels für Exposition gegenüber einer Siliziumschmelze beim Züchten von Siliziumeinkristall in einem Czochralski-Verfahren, wobei der Prozess umfasst:
Beschichten von mindestens 75% der der Siliziumschmelze auszusetzenden Oberfläche mit einem Beschichtungsmaterial, welches ein Organosilanhalogen oder ein Organogermanhalogen und Mischungen derselben umfasst.

10. Prozess nach Anspruch 9, welcher weiterhin die folgenden Schritte umfasst:
Auflösen des Beschichtungsmaterials in einem Lösungsmittel gewählt aus der Gruppe von Alkanen, halogenierten Alkanen, Alkoholen und Mischungen derselben;
Beschichten der Oberfläche des Tiegels durch Aufbringen des aufgelösten Beschichtungsmaterials auf die der Siliziumschmelze auszusetzende Tiegeloberfläche.

11. Prozess nach Anspruch 9 oder 10, wobei das Beschichtungsmaterial durch eines von:
Aufsprühen des Beschichtungsmaterials auf den Tiegel, Aufstreichen des Beschichtungsmaterials auf den Tiegel, Tauchen des Tiegels in das Beschichtungsmaterial und Kombinationen derselben aufgebracht wird.

12. Prozess nach Anspruch 9, welcher weiterhin die folgenden Schritte umfasst:
Ausbilden eines Schlickers, welcher ein pulverförmiges kristallines Material und ein Organosilanhalogen oder ein Organogermanhalogen umfasst;
Auflösen des Schlickers in einem Lösungsmittel gewählt aus der Gruppe von Alkanen, halogenierten Alkanen, Alkoholen und Mischungen derselben;
Beschichten der Oberfläche des Tiegels durch Aufbringen des aufgelösten Schlickers auf die der Siliziumschmelze auszusetzende Tiegeloberfläche; und
20 bis 40 Minuten lang Glühen des beschichteten Tiegels bei einer Temperatur in einem Bereich von 100°C bis 150°C.

13. Prozess nach Anspruch 12, wobei das Lösungsmittel gewählt wird aus der Gruppe von Chloroform, Tetrachlorkohlenstoff, Trichlorethan, Trichlorpropan, Methanol, Ethanol, n-Propanol, Isopropanol, n-Butanol, t-Butanol, n-Octanol, n-Decanol, Ethylenglycol, Hexan, Decan, Isooctan, Benzen, Toluen, den Xylenen, Dioxan, Diethylether, Dibutylether, Bis(2-methoxyethyl)ether, 1,2-Dimethoxyethan, Butan, Pentan, Hexan, Dichlormethan, Trichlormethan, Tetrachlormethan, 1,2-Dichlorethan, Trichlorethylen; 1,1,1-Trichlorethan, einem Tetrachlorethylen und Chlorbenzol;

14. Prozess nach Anspruch 12 oder 13, wobei das Beschichtungsmaterial durch eines von:
Aufsprühen des Beschichtungsmaterials auf den Tiegel, Aufstreichen des Beschichtungsmaterials auf den Tiegel, Tauchen des Tiegels in das Beschichtungsmaterial und Kombinationen derselben aufgebracht wird.

## Revendications

1. Creuset en verre de quartz destiné à être utilisé pour faire croître un monocristal de silicium dans une opération de Czochralski et à être exposé à un bain fondu de silicium, le creuset contenant au moins 99,0 % de SiO₂ et comprenant :
une surface sur laquelle est appliqué un matériau de revêtement fournissant une pluralité d'espèces chimiques ayant une chimie réduite sur la surface revêtue, où le matériau de revêtement comprend un organosilane halogéné ou un organogermane halogéné, où
le matériau de revêtement recouvre au moins 75 % de la surface du creuset exposée au bain fondu de silicium.

2. Creuset selon la revendication 1, où
le matériau de revêtement recouvre au moins 90 % de la surface du creuset exposée au bain fondu de silicium.

3. Creuset selon une quelconque revendication précédente, ou
le matériau de revêtement comprend l'un au moins d'un trialkylchlorogermane ; dialkyldichlorogermane, dialkyldihalogénosilane et dialkyldihalogénogermane.

4. Creuset selon la revendication 3, où
le matériau de revêtement comprend au moins l'un d'un (alkyl)₂GeCl₂, d'un (alkyl)₂GeBr₂, d'un (alkyl)₂GeF₂ et d'un (aryl)₂GeCl₂, et de mélanges de ceux-ci.

5. Creuset selon une quelconque revendication précédente, où
le matériau de revêtement comprend au moins l'un d'un (alkyl)₂SiCl₂, d'un (alkyl)₂SiBr₂, d'un (alkyl)₂SiF₂ et d'un (aryl)₂SiCl₂, et de mélanges de ceux-ci.

6. Creuset selon une quelconque revendication précédente, où
le matériau de revêtement comprend en outre un matériau cristallin en poudre et de préférence de la silice cristalline.

7. Creuset selon la revendication 6, où
le matériau cristallin a une taille moyenne de particule inférieure à 50 pm et de préférence inférieure à 20 µm.

8. Creuset selon la revendication 6 or 7, où
le matériau cristallin est du quartz alpha, du quartz bêta ou de la cristobalite.

9. Procédé de préparation d'au moins une surface d'un creuset en verre de quartz destiné à être exposé à un bain fondu de silicium lors de la croissance d'un monocristal de silicium dans une opération de Czochralski, le procédé comprenant :
le revêtement d'au moins 75 % de la surface destinée à être exposée au bain fondu de silicium avec un matériau de revêtement comprenant un organosilane halogéné ou un organogermane halogéné, et des mélanges de ceux-ci.

10. Procédé selon la revendication 9, comprenant en outre les étapes consistant à :
dissoudre le matériau de revêtement dans un solvant choisi dans le groupe des alcanes, alcanes halogénés, alcools et mélanges de ceux-ci ;
revêtir la surface du creuset par application du matériau de revêtement dissous sur la surface du creuset destinée à être exposée au bain fondu de silicium.

11. Procédé selon la revendication 9 ou 10, où
le matériau de revêtement est appliqué par l'une des méthodes suivantes :
pulvérisation du matériau de revêtement sur le creuset, application du matériau de revêtement à la brosse sur le creuset, trempage du creuset dans le matériau de revêtement, et des combinaisons de celles-ci.

12. Procédé selon la revendication 9, comprenant en outre les étapes consistant à :
former une bouillie comprenant un matériau cristallin en poudre et un organosilane halogéné ou un organogermane halogéné ;
dissoudre la bouillie dans un solvant choisi dans le groupe des alcanes, des alcanes halogénés, des alcools et de mélanges de ceux-ci ;
revêtir la surface du creuset par application de la bouillie dissoute sur la surface du creuset destinée à être exposée au bain fondu de silicium ; et
recuire le creuset revêtu à une température dans une plage de 100 °C à 150 °C pendant 20 à 40 minutes.

13. Procédé selon la revendication 12, où
le solvant est choisi dans le groupe constitué de chloroforme, tétrachlorure de carbone, trichloroéthane, trichloropropane, méthanol, éthanol, n-propanol, isopropanol, n-butanol, t-butanol, n-octanol, n-décanol, éthylène glycol, hexane, décane, isooctane, benzène, toluène, xylènes, dioxane, éther diéthylique, éther dibutylique, bis(2-méthoxyéthyl)éther, 1,2-diméthoxyéthane, butane, pentane, hexane, dichlorométhane, trichlorométhane, tétrachlorométhane, 1,2-dichloroéthane, trichloroéthylène ; 1,1,1-trichloroéthane, tétrachloroéthylène et chlorobenzène ;

14. Procédé selon la revendication 12 ou 13, où
le matériau de revêtement est appliqué par l'une des méthodes suivantes :
pulvérisation du matériau de revêtement sur le creuset, application du matériau de revêtement à la brosse sur le creuset, trempage du creuset dans le matériau de revêtement, et des combinaisons de celles-ci.
